# EUROPEAN PATENT SPECIFICATION

(11) **EP 2 562 197 B1**
(45) Date of publication and mention of the grant of the patent: **01.08.2018**
(21) Application number: 10850056.2
(22) Date of filing: 23.04.2010
(51) Int. Cl.: H01L 51/46, C08G 61/10

(54) **COPOLYMER COMPRISING ANTHRACENE AND BENZOSELENADIAZOLE, PREPARING METHOD AND USES THEREOF**
COPOLYMER MIT ANTHRACEN UND BENZOSELENADIAZOL, HERSTELLUNGSVERFAHREN UND VERWENDUNG
COPOLYMÈRE COMPRENANT DE L'ANTHRACÈNE ET DU BENZOSÉLÉNADIAZOLE, SON PROCÉDÉ DE PRÉPARATION ET SES UTILISATIONS

(43) Date of publication of application: 27.02.2013
(73) Proprietor: OCEAN'S KING LIGHTING SCIENCE & TECHNOLOGY CO., LTD., Guangdong 518054 (CN)
(72) Inventor: ZHOU, Mingjie, Shenzhen Guangdong 518054 (CN); HUANG, Jie, Shenzhen Guangdong 518054 (CN); HUANG, Jiale, Shenzhen Guangdong 518054 (CN)
(74) Representative: Johnson, Richard Alan
(86) International application number: PCT/CN2010/072153
(87) International publication number: WO 2011/130922

(56) References cited:
- WO-A1-2010/020329
- WO-A1-2010/031479
- WO-A1-2010/031480
- RENQIANG YANG ET AL: "Synthesis and Optical and Electroluminescent Properties of Novel Conjugated Copolymers Derived from Fluorene and Benzoselenadiazole", MACROMOLECULES, vol. 36, no. 20, 1 October 2003 (2003-10-01), pages 7453-7460, XP055427595, US ISSN: 0024-9297, DOI: 10.1021/ma034134j
- CAO WEI ET AL.: 'Synthesis and properties of polycarbazole/fluorene-based conjugated polyelectrolytes with 2,1,3-benzoselenadiazole and their precursors' ACTA POLYMERICA SINICA no. 6, 2007, pages 566 - 572, XP008168767
- HOU QIONG ET AL.: 'Synthesis and electroluminescent properties of fluorene-based red emitting copolymers' CHINESE JOURNAL OF APPLIED CHEMISTRY vol. 26, no. 2, 2009, pages 163 - 165, XP008168712
- MAVLUDA OMARALY ET AL.: 'Synthesis and characterization of benzoselenadiazole-containing poly(aryleneethynylene) conjugated polymers' JOURNAL OF FUNCTIONAL MATERIALS vol. 40, no. 7, 2009, pages 1063 - 1067, XP008168733

## Description

### FIELD OF THE INVENTION

The invention relates to the field of organic material technology, in particular to copolymers having repeating units comprising anthracene and benzoselenadiazole, their preparation methods and uses thereof.

### BACKGROUND OF THE INVENTION

Organic material has been the research focus, which popularly used in copolymer material at present. Research and development in this area is increasing. Its application as optoelectronic material or semiconductor material is becoming one of the hotspots in the field of energy. A typical application of such material is in a solar cell, for example.

Traditional solar cells with high efficiency normally use an inorganic semiconductor as raw material, but commercial development of the main silicon wafer solar cell is repressed by complicated productive technology, heavy pollution, energy-wasting and high cost. Thus, challenging research efforts in the field of photovoltaics aim to take advantage of a low-priced material to produce low-cost solar cell with high efficiency. For instance, organic material is of good environmental stability, excellent suppleness, film-forming properties, low-cost, and easily controlled. Furthermore, the process of an organic solar cell is relatively simple; it can be operated at low temperature. The production cost of such devices is also cheaper. Due to these advantages, organic material has attracted much attention as a cheap and attractive material for solar cells. Moreover, the potential advantages of organic solar cells include the following: they can be manufactured on a large scale, they can use a flexible substrate, they are environmentally friendly, and they are portable, etc.

Organic photovoltaic material has these advantages, like good thermal stability, ease of processing and low cost. It can achieve specific photoelectric functions by molecular design. Based on such advantages, organic photovoltaic material can be implemented in semiconductor or photoelectric devices. For example, a copolymer solar cell is a new kind of solar cell, which typically uses organic material. Some advantages of copolymer solar cells cannot be matched by inorganic solar cells, such as extensive material resources, diversity of controllable structure, low cost, safety, process simplicity, light quality and flexibility of large scale manufacture. Possessing important development and application prospects, it can be implemented in building construction, lighting, power generation and other fields. Nevertheless, efficiency of the photon-to-electron conversion of a copolymer solar cell is much lower than that of an inorganic solar cell so far. In Yang et al. Macromolecules 2003, 36, 7452 a novel series of light-emitting copolymers derived from 9,9-dioctylfluorene (DOF) and 2,1,3-benzoselenadiazole (BSeD) is prepared by means of palladium-catalyzed Suzuki coupling reaction. The feed ratios of DOF to BSeD were 50:50, 85:15, 92:8, and 98:2, respectively. The resulting copolymers are said to be soluble in common organic solvents and fluorescent in solid state. Devices from such copolymers emit orange-red light with λₘₐₓ = 570-600 nm. The maximal EL emissions of the devices slightly redshifted gradually with increasing BSeD's contents. The maximal external quantum efficiency of the polymer light-emitting devices (FLED) is said to reach 1.0%.

### SUMMARY OF THE INVENTION

For that reason, a copolymer comprising anthracene and benzoselenadiazole with good stability which has a wide wavelength range of spectrum response and a simple, low-cost preparing method of copolymer comprising anthracene and benzoselenadiazole is provided.

The uses of said copolymer comprising anthracene and benzoselenadiazole are also provided in the embodiments of the present invention.

A copolymer comprising anthracene and benzoselenadiazole which is represented by the following formula (I): 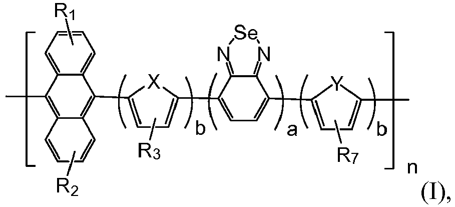 wherein n is a natural number from 10 to 1000, a is 1 or 2, b is 0, 1 or 2, X, Y are O, S, Se or SO₂, N-R₄, R₅-Si-R₆; R₄, R₅, R₆ are selected from C₁-C₂₀ straight-chain, branched-chain or cyclo alkyl or alkoxy; R₁, R₂ are unsubstituted, monosubstituted or polysubstituted functional group An, and the functional group An is selected from hydrogen, halogen, cyano, substituted or unsubstituted C₁-C₄₀ straight-chain or branched-chain or cyclo alkyl, substituted or unsubstituted aryl or heteroaryl; R₃, R₇ are unsubstituted, monosubstituted or polysubstituted functional group Ar₂, and the functional group Ar2 is selected from hydrogen, cyano, substituted or unsubstituted C₁-C₄₀ straight-chain or branched-chain or cyclo alkyl, substituted or unsubstituted C₁-C₄₀ alkoxy, substituted or unsubstituted C₆-C₄₀ aryl, substituted or unsubstituted C₆-C₄₀ aralkyl, substituted or unsubstituted C₆-C₄₀ aryl alkoxy.

A method of preparing a copolymer comprising anthracene and benzoselenadiazole, comprising:
providing compounds A and B represented by the following formula, respectively:
   A: 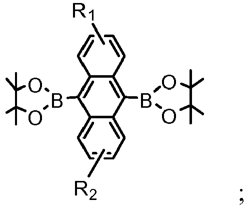 B: 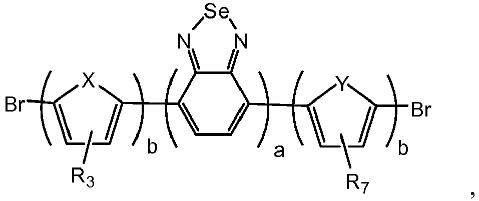 wherein a is 1 or 2; b is 0,1 or 2; X, Y are O, S, Se or SO₂, N-R₄, R₅-Si-R₆; R₄, R₅, R₆ are selected from C₁-C₂₀ straight-chain, branched-chain or cyclo alkyl or alkoxy; R₁, R₂ are unsubstituted, monosubstituted or polysubstituted functional group An, and the functional group An is selected from hydrogen, halogen, cyano, substituted or unsubstituted C₁-C₄₀ straight-chain or branched-chain or cyclo alkyl, substituted or unsubstituted aryl or heteroaryl; R₃, R₇ are unsubstituted, monosubstituted or polysubstituted functional group Ar₂, and the functional group Ar₂ is selected from hydrogen, cyano, substituted or unsubstituted C₁-C₄₀ straight-chain or branched-chain or cyclo alkyl, substituted or unsubstituted C₁-C₄₀ alkoxy, substituted or unsubstituted C₆-C₄₀ aryl, substituted or unsubstituted C₆-C₄₀ aralkyl, substituted or unsubstituted C₆-C₄₀ aryl alkoxy;
Polymerisation of compound A and compound B was carried out in the presence of catalyst, alkaline solution and organic solvent and under oxygen-free environment, the polymerization represented by following formula: 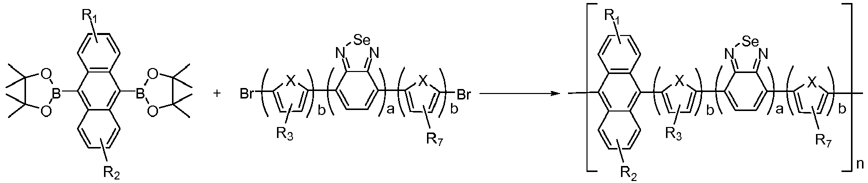 wherein n is a natural number from 10 to 1000, to produce said copolymer comprising anthracene and benzoselenadiazole.

Also, the uses of said copolymer comprising anthracene and benzoselenadiazole includes use in organic optoelectronic materials, polymer solar cell devices, organic field effect transistors, organic light-emitting devices, organic optical storage devices, organic nonlinear materials or organic laser devices.

In said copolymer comprising anthracene and benzoselenadiazole, the stability and film-forming properties of the polymer are improved by taking advantage of the excellent stability and good film-forming properties of anthracene and its derivatives. Also, said copolymer comprising anthracene and benzoselenadiazole, which is a type of excellent organic semiconductor material, has appropriate carrier transport properties, the hole mobility of its crystal reaches 3 cm²/V·s at room temperature. Moreover, because the atom radius of selenium (Se) is 103 pm, which exceeds that of some heteroatoms such as sulfur (88 pm), it enhances the molecular overlap between the molecular chains, thereby promoting charge hopping motion to endow copolymer comprising anthracene and benzoselenadiazole with a higher carrier mobility. And, by the introduction of benzoselenadiazole unit into copolymer comprising anthracene and benzoselenadiazole, it has a strong electron transfer ability; also can increase backbone electron cloud density of the copolymer, narrow the band gap of the copolymer, broaden the absorption range of the copolymer to solar spectrum. In said preparation method of the copolymer comprising anthracene and benzoselenadiazole, manufacturing costs can be reduced by using a relatively simple synthetic route. Based on the above advantages, said copolymer comprising anthracene and benzoselenadiazole can be implemented in said materials or devices to improve the photoelectric or semiconductor performance, reduce the weight of devices, and facilitate manufacture on a large scale.

### BRIEF DESCRIPTION OF THE DRAWINGS

The present invention will now be described, by way of example only, with reference to the accompanying drawings, in which:
Fig. 1 shows the formula of a copolymer comprising anthracene and benzoselenadiazole in the embodiments of the present invention.
Fig. 2 shows the flow chart of the preparation method of copolymer comprising anthracene and benzoselenadiazole in the embodiments of the present invention.
Fig. 3 shows the structure diagram of solar cell device with the copolymer comprising anthracene and benzoselenadiazole in the embodiments of the present invention.
Fig. 4 shows the structure diagram of organic light-emitting device with the copolymer comprising anthracene and benzoselenadiazole in the embodiments of the present invention.
Fig. 5 shows the structure diagram of organic field effect transistors with the copolymer comprising anthracene and benzoselenadiazole in the embodiments of the present invention.

### DETAILED DESCRIPTION OF ILLUSTRATED EMBODIMENTS

The present invention will now be described, by way of example only, with reference to the accompanying drawings, in order to make the purpose, the technical solution and the advantages clearer. While the present invention has been described with reference to particular embodiments, it will be understood that the embodiments are illustrative.

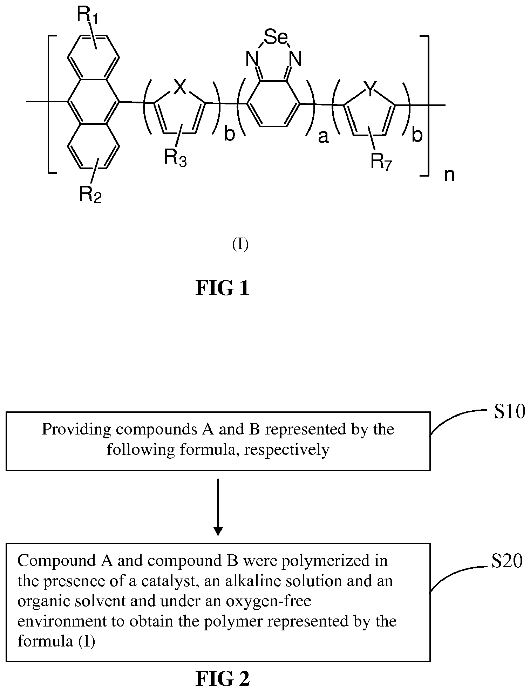

Referring to Fig.1, a copolymer comprising anthracene and benzoselenadiazole is provided in the embodiments of the present invention, which is represented by the following formula (I): 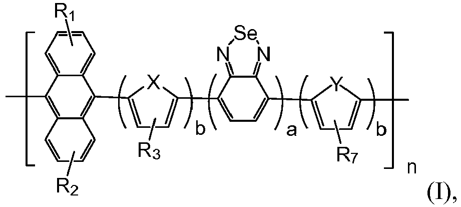 wherein n is a natural number from 10 to 1000, a is 1 or 2, b is 0, 1 or 2, X, Y are O, S, Se or SO₂, N-R₄, R₅-Si-R₆; R₄, R₅, R₆ are selected from C₁-C₂₀ straight-chain, branched-chain or cyclo alkyl or alkoxy; R₁, R₂ are unsubstituted, monosubstituted or polysubstituted functional group An, and said functional group An is selected from hydrogen, halogen, cyano, substituted or unsubstituted C₁-C₄₀ straight-chain or branched-chain or cyclo alkyl, substituted or unsubstituted aryl or heteroaryl; R₃, R₇ are unsubstituted, monosubstituted or polysubstituted functional group Ar₂, and said functional group Ar₂ is selected from hydrogen, cyano, substituted or unsubstituted C₁-C₄₀ straight-chain or branched-chain or cyclo alkyl, substituted or unsubstituted C₁-C₄₀ alkoxy, substituted or unsubstituted C₆-C₄₀ aryl, substituted or unsubstituted C₆-C₄₀ aralkyl, substituted or unsubstituted C₆-C₄₀ aryl alkoxy.,

Wherein, R₁ and R₂ are preferably the same functional group An to enhance the molecule structure symmetry of copolymer. When b is not 0, each unit of copolymer contains at least a quinary heterocycle unit, and the heterocyclic atoms or groups are O, S, N, Si, Se or SO₂. All the units have quinary heterocyclic structure, which follows the Huckel rule, and have moderate band gap, wide wavelength range of spectrum response, good thermal and environmental stability. In an embodiment, when b is not 0, that is, b is 1 or 2, each unit of copolymer contains more said quinary heterocycle unit, which improves its performance. R₄, R₅, R₆ are selected from C₁-C₂₀ straight-chain, branched-chain or cyclo alkyl or alkoxy, which can be the alkyl chain or alkoxy chain with more carbon atoms such as alkyl or alkoxy with more than 6 carbon atoms (C₆). n is a natural number from 10 to 100.

X, Y can be the same or different, for example, X and Y may both be Se.Because the atom radius of selenium (Se) is 103 pm, which exceeds that of some heteroatom such as sulfur (88 pm), it enhances the molecular overlap between the molecular chains and promotes charge hopping motion to endow copolymer comprising anthracene and benzoselenadiazole with higher carrier mobility. When X, Y is any one of N-R₆, Si-R₇-R₈, it is able to introduce alkyl or alkoxy into nitrogenous thiophene or silicon thiophene, resulting in improvement of the dissolved performance of the material, film processing and number of applications.

Functional group An is preferably halogen, cyano, substituted or unsubstituted C₁-C₄₀ straight-chain or branched-chain or cyclo alkyl, substituted or unsubstituted aryl or heteroaryl. When functional group Ar₁ is halogen, cyano, aryl heteroaryl group and other electron-withdrawing groups the stability of the material is improved. Furthermore, due to the expansion of conjugated structure and improvement of molecule planar properties, it's favorable for narrowing the band gap of the material so that the solar spectral absorption range of copolymer is broader, improving photon-to-electron conversion efficiency. When functional group An is substituted or unsubstituted C₁-C₄₀ straight-chain or branched-chain or cyclo alkyl, substituted or unsubstituted aryl or heteroaryl, for one thing, through the introduction of alkyl or aryl or heteroaryl to improve the dissolved performance of material, it's favorable for film reforming process and enlargement of its application. When functional group An is C₁-C₄₀ straight-chain or branched-chain or cyclo alkyl, alkyl with more than 18 carbon atoms (Cis) is preferred, for enhancement of the polymer molecular weight, getting better dissolved performance, and good for film reforming process.

Like functional group An, for improving the performance of copolymer, functional group Ar₂ is preferably cyano, substituted or unsubstituted C₁-C₄₀ straight-chain or branched-chain or cyclo alkyl, substituted or unsubstituted Ci-C₄₀ alkyl, substituted or unsubstituted C₆-C₄₀ aryl, substituted or unsubstituted C₆-C₄₀ aralkyl, substituted or unsubstituted C₆-C₄₀ aryl alkoxy.

Said unit of copolymer comprising anthracene and benzoselenadiazole may contain several thiophene rings and other quinary heterocycle units. Said structure unit endows the copolymer with a moderate band gap and a wide spectrum responding wavelength range, which is around 300-700 nm, largely covering that of the visible light. It also has good thermal, environmental stability and shows good photoelectric properties.

Referring to Fig.2, said method of preparing a copolymer comprising anthracene and benzoselenadiazole, comprising:
S10: Providing compounds A and B represented by the following formula, respectively:
   A: 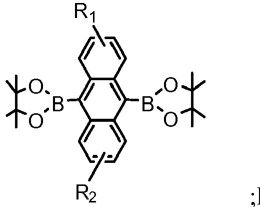 B: 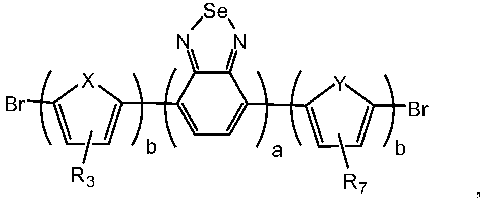 wherein a is 1 or 2, b is 0, 1 or 2, X, Y are O, S, Se or SO₂, N-R₄, R₅-Si-R₆. R₄, R₅, R₆ are selected from C₁-C₂₀ straight-chain, branched-chain or cyclo alkyl or alkoxy; R₁, R₂ are unsubstituted, monosubstituted or polysubstituted functional group Ar₁, and said functional group Ar₁ is selected from hydrogen, halogen, cyano, substituted or unsubstituted C₁-C₄₀ straight-chain or branched-chain or cyclo alkyl, substituted or unsubstituted aryl or heteroaryl; R₃, R₇ are unsubstituted, monosubstituted or polysubstituted functional group Ar₂, and said functional group Ar₂ is selected from hydrogen, cyano, substituted or unsubstituted C₁-C₄₀ straight-chain or branched-chain or cyclo alkyl, substituted or unsubstituted C₁-C₄₀ alkoxy, substituted or unsubstituted C₆-C₄₀ aryl, substituted or unsubstituted C₆-C₄₀ aralkyl, substituted or unsubstituted C₆-C₄₀ aryl alkoxy.
S20: Polymerisation of compound A and compound B was carried out in the presence of catalyst, alkaline solution and organic solvent and under oxygen-free environment, the polymerization represented by following formula: 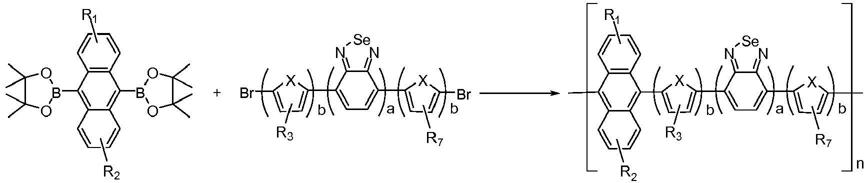 wherein n is a natural number from 10 to 1000, to produce said copolymer comprising anthracene and benzoselenadiazole.

In the step S10, compounds A and B are commercially available or can be prepared using existing synthesis methods, which is not discussed here. Wherein, each group in compounds A and B is almost the same as the description of said copolymer comprising anthracene and benzoselenadiazole, which is not discussed here.

In the present embodiment, compounds A and B are freshly made. Firstly, the specific preparation of compound A is described as follows:

In anhydrous oxygen-free reactor, under continuous stirring and an atmosphere of N₂, add a pale yellow crystal-like 9,10-dibromoanthracene (*i.e.* Compound A in the following equations.) and organic solvent, then add *n*-BuLi at a temperature in the range of -78°C to -25°C. The reaction system turns orange red from pale yellow, stir for several hours. After the reaction, inject 2-isopropoxy-4,4,5,5-tetramethyl-1,3,2-dioxaborolane at a temperature in the range of -78°C to -25°C and the whole reaction system turns pale yellow from orange red. When the temperature rises to room temperature, conduct the reaction overnight (such as 12-14 hours). After the reaction, purification and separation are performed which includes: adding saturated sodium chloride aqueous solution to the reaction solution, extracting with chloroform, drying with anhydrous sodium sulfate. Collect the filtrate and rotary evaporate solvent after leaching. At last, separate the colature by column chromatography on silica gel column with petroleum ether-ethyl acetate used as eluent to get product compound A, and test products. Organic solvent can be weak polar or polar aprotic organic solvent or a mixed solvent thereof, such as but not limited to tetrahydrofuran, ethanol, methanol, dichloromethane, trichloromethane, ethyl acetate, dimethyl formamide, methylbenzene or acetone, etc. Tetrahydrofuran is preferred. An anhydrous oxygen-free reactor is mainly under the protective atmosphere of nitrogen. Of course, the reaction can be carried out under the protection of other inert gases such as neon, argon, but it is not limited to these. Specific equation is represented as follows:

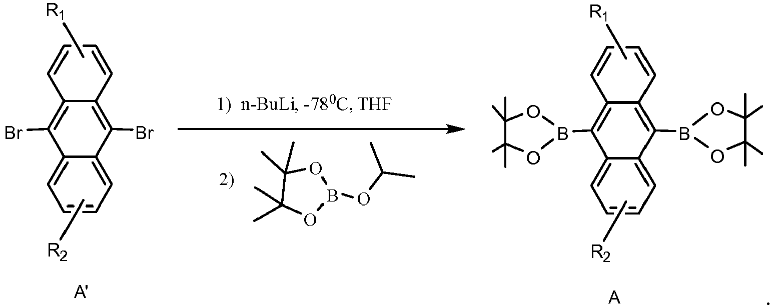

Compound B comprises at least one unit, that is, it includes at least one benzoselenadiazole unit, and optionally it includes a thiophene unit and other quinary heterocycle units. When it only contains one benzoselenadiazole unit, that is, the b in the formula (I) is 0 and a is 1, the raw material of benzoselenadiazole monomer is its dibromide, which can be obtained by the following steps:
(1) Preparation of 3,6-dibromo-1,2-diaminobenzene, of which the equation is represented as follows: 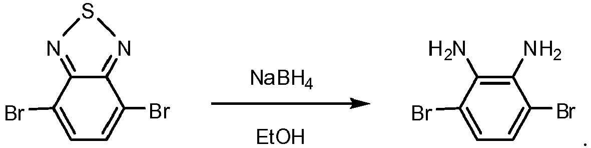
   The specific preparation is described as follows: dissolve 4,7-dibromo-2,1,3-benzothiadiazole in organic solvent such as ethanol, add appropriate sodium borohydride at 0°C, then raise the temperature to room temperature, stir for 12-24 hours, distill organic solvent of reaction product, after adding water, wash with saline water, then extract with diethyl ether and dry with anhydrous sodium sulfate. 3,6-dibromo-1,2-diaminobenzene is obtained after solvent is rotary dried.
(2) Preparation of 4,7-dibromo-2,1,3-benzoselenadiazole, of which the equation is represented as follows: 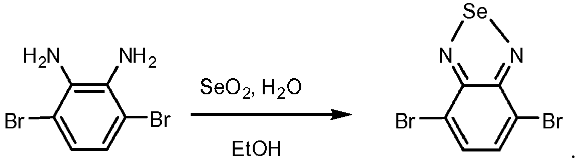
   The specific preparation is described as follows: reflux 3,6-dibromo-1,2-diaminobenzene in ethanol solution, then add to selenium dioxide dissolved in hot water, reflux for 2 hours. Recrystallise the precipitate with ethyl acetate after being filtered to obtain the final product.

When compound B includes only one benzoselenadiazole unit, that is when the b in formula (I) is 0 and a is 2, it is a dibenzoselenadiazole monomer, of which the raw material is its dibromide likewise. It can be obtained by the following steps:
(1) Preparation of 3-bromo-1,2-diaminobenzene, of which the equation is represented as follows: 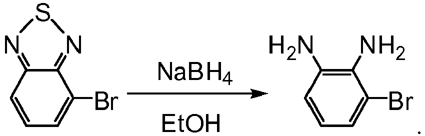
   The specific preparation is described as follows: dissolve 4-bis(2,1,3-benzothiadiazole) in organic solvent such as ethanol, add appropriate sodium borohydride at 0°C, then raise the temperature to room temperature, stir for 12-24 hours, distill organic solvent of reaction product, after adding water, wash with saline water, then extract with diethyl ether before drying with anhydrous sodium sulfate. 3-bromo-1,2-diaminobenzene is obtained after solvent is rotary dried.
(2) Preparation of 4-bromo-2,1,3-benzoselenadiazole, of which the equation is represented as follows: 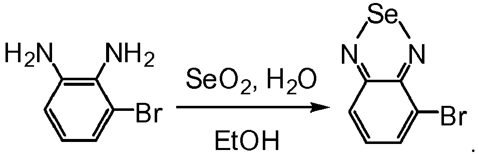
   The specific preparation is described as follows: reflux 3-bromo-1,2-diaminobenzene in ethanol solution, then add into selenium dioxide dissolved in hot water, after that, reflux for 2 hours. Recrystallize the precipitate with ethyl acetate after being filtered to obtain 4-bromo-2,1,3-benzoselenadiazole.
(3) Preparation of 4-4,4,5,5-tetramethyl-1,3,2-dioxaborolane-2,1,3-benzoselenadiazole, of which the specific equation is represented as follows: 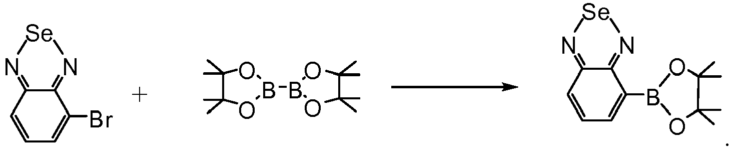
   The specific preparation is described as follows: dissolve 4-bromo-2,1,3-benzoselenadiazole, bis(pinacolato)diboron, potassium acetate in dry 1,4-dioxane and bubble with nitrogen. Then add 1,1-bis(diphenylphosphino) ferrocene palladium dichloride, heat and stir for 20 hours at 105 °C. Extract with ethyl acetate after washing with saturated salt solution, dry through anhydrous sodium sulfate, separate and purify on silica gel column with ethyl acetate and normal hexane used as solvent to obtain the product represented in the equation.
(4) Preparation of bis(2,1,3-benzoselenadiazole), of which the specific equation is represented as follows: 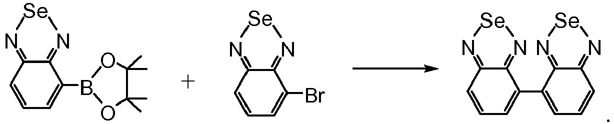
   The specific preparation is described as follows: place borate ester substituted product of 4-bromo-2,1,3-benzoselenadiazole (*i.e.* the product obtained in step(3)), 4-bromo-2,1,3-benzoselenadiazole, palladium-tetrakis (triphenylphosphine) and sodium carbonate aqueous solution into a reactor, stir for 20 hours under the deoxygenization at 100°C. Extract with dichloromethane after washing with saturated salt solution, dry through anhydrous sodium sulfate, separate and purify on a silica gel column with ethyl acetate and normal hexane which is used as solvent to obtain product represented in the equation.
(5) Preparation of 7,7'-dibromo-4,4'-bis(2,1,3-benzoselenadiazole), of which the specific equation is represented as follows: 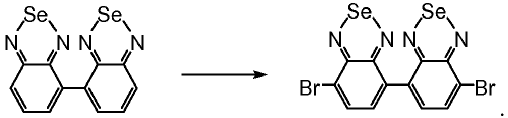
   The specific preparation is described as follows: dissolve dibenzoselenadiazole obtained in step (4) in hydrobromide, add Br₂, stir for 3 days at 130 °C. Add saturated sodium sulfate solution into the reaction solution, leach and vacuum dry to get 7,7'-dibromo-4,4'-bis(2,1,3-benzoselenadiazole) product as compound B.

When compound B comprises at least one quinary heterocycle unit besides a benzoselenadiazole unit, that is, the b in the formula (I) is 1 or 2, of which the raw material is its dibromide likewise. There are four cases specifically: (i)a=b=1; (ii)a=b=2; (iii)a=1, b=2, (vi)a=2, b=1. The preparation of compound B under these cases will be illustrated in the following embodiments in detail.

In the step S20, the catalyst provided in polymerization is an organopalladium catalyst or a mixture of an organopalladium catalyst and organic phosphine ligands, of which the amount is equivalent to 0.5%-10% of the molar amount of compound A. The provided organic solvent is methylbenzene, tetrahydrofuran, glycol dimethyl ether, benzene or *N*,*N*-dimethyl formamide. The alkaline solution can be an inorganic alkaline solution or an organic alkaline solution. The inorganic alkaline solution can be alkali metal hydroxide or an aqueous solution of alkali metal carbonate, for instance, it can be, but is not limited to, sodium hydroxide solution, potassium hydroxide, sodium carbonate solution, potassium carbonate solution and so on. Sodium carbonate solution is preferred. Organic alkaline solution can be an aqueous solution of alkyl ammonium hydroxide, for instance, it can be, but is not limited to, tetramethyl ammonium hydroxide, tetraethyl ammonium hydroxide, tetrapropyl ammonium hydroxide, tetrabutyl ammonium hydroxide and other aqueous solutions. The amount of said alkaline solution can be 5 to 10 times as much as the molar amount of compound A. When catalyst provided in the polymerization is an organopalladium catalyst or a mixture of organopalladium catalyst and organic phosphine ligands, in said mixture the molar ratio of organopalladium catalyst to organic phosphine ligands is 1:2 to 20. The organic solvent is a weak polar or polar aprotic organic solvent or its mixed solvent, for instance, it can be, but is not limited to, chloroform, dichloromethane, glycol dimethyl ether, dimethyl sulfoxide (DMSO), tetrahydrofuran (THF), methylbenzene, dimethylbenzene or its similar compounds. Methylbenzene is preferred. A sufficient amount of solvent enables various reactants to dissolve and react completely. Polymerization reacts for 1 to 7 days under the temperature in the range of 60 °C to 100 °C.

The specific process of polymerization is described as follows: add compounds A and B, catalyst, alkaline solution, and organic solvent into a reactor to have a reaction system without oxygen and react for 1 to 7 days at a temperature in the range of 60 °C to 100 °C. After the reaction, add deionized water and organic solvent to reactor of the product to carry out the extraction. Take the organic phase, evaporate the polymer/organic solvent by vacuum distillation method, drip it into anhydrous methanol and stir continuously for several hours, a solid will gradually precipitate. The solid powder obtained after being leached and dried is the polymerization product.

After obtaining the polymerization product, conduct a purification as follows: dissolve the polymerization product, that is, the solid powder, in chloroform, purify by means of column chromatography on neutral aluminum oxide chromatographic column removing catalyst, and then rotary evaporate the polymerization product and chloroform solution, drip methanol solvent and stir for several hours, dry, extract copolymer in Soxhlet extractor to obtain the copolymer comprising anthracene and benzoselenadiazole.

In said reaction steps, the amount of reactants can be according to the stoichiometric ratio shown in equation, but also, part of reactants can be in excess, where the preparing method of the present embodiment can be carried out without impacting the reaction.

In said preparing method of the copolymer comprising anthracene and benzoselenadiazole, monomers compounds A and B can synthesize the desired product; the synthetic route is relatively simple and mature, thereby reducing the process, reducing manufacturing costs. And in the preparation process, it is easy to improve the solubility of the product and promote the film processing performance of copolymer through the introduction of alkyl or alkoxy.

The copolymer in the present embodiment can be implemented in various photoelectric or semiconductor technology fields, for instance, in organic optoelectronic materials, polymer solar cell devices, organic field effect transistors, organic light-emitting devices, organic optical storage devices, organic nonlinear materials and organic laser devices, etc. Wherein, organic optoelectronic materials include said copolymer comprising anthracene and benzoselenadiazole which is used as electron donor material and/or photon-to-electron conversion material, etc. Further examples include solar cell devices, organic field effect transistors, and organic light-emitting devices as examples. Others like organic optical storage devices, organic nonlinear materials and organic laser devices are similar to the followings, which all use the copolymer in the present embodiment as their optical storage material, nonlinear materials, laser materials or semiconductor materials, etc.

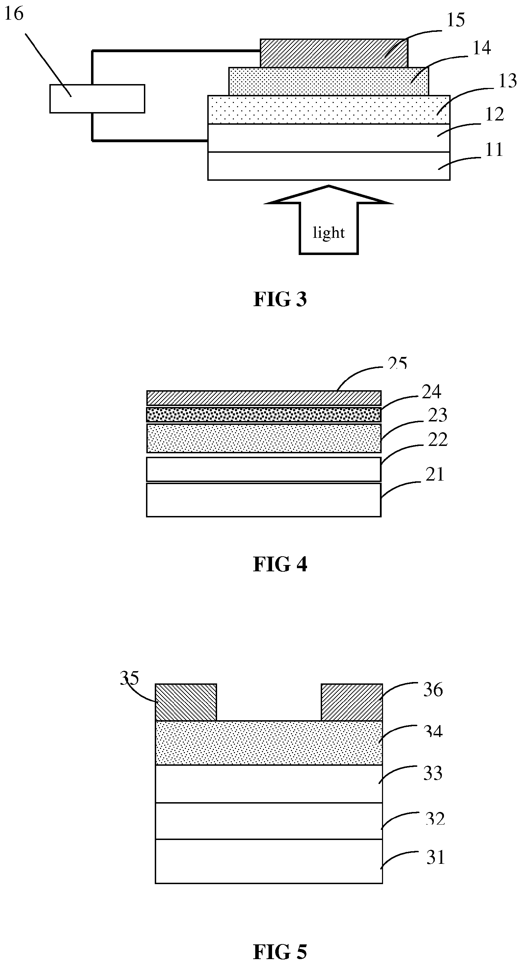

Referring to Fig.3, a solar cell device, in which the copolymer comprising anthracene and benzoselenadiazole in the present embodiment is provided, includes glass base layer 11, transparent anode 12, middle auxiliary layer 13, active layer 14, cathode 15, which stack successively. Buffer layer 13 uses a polyethylene 3,4-thiophene: polystyrene - sulfuric acid composite (abbr. PEDOT:PSS), active layer 14 includes electron donor material and electron acceptor material, an electron donor material uses said copolymer comprising anthracene and benzoselenadiazole, the electron acceptor material can be [6,6] phenyl-C₆₁- methyl butyrate (abbr. PCBM). Transparent anode 12 can be indium tin oxide (abbr. ITO), preferably for indium tin oxide with square resistance of 10 to 20 Ω. The cathode 15 can be aluminum electrode, but not limited to it. Wherein, glass basement 11 can be the bottom layer. During the making, deposit ITO electrode on glass basement 11, and then forming middle auxiliary layer 13 in ITO electrode by oxygen - plasma spraying (oxygen-Plasma) treatment process, and deposit copolymer comprising anthracene and benzoselenadiazole and electron acceptor materials on middle auxiliary layer 13 by spin-coating to form an active layer 14. Then deposit cathode 15 on the active layer 14 through vacuum evaporation to obtain the above-mentioned solar cell devices.

As shown, in the light, the light goes through glass base layer 11 and ITO electrode 12. The copolymer comprising anthracene and benzoselenadiazole in active layer 14 absorbs solar energy, and generates excitons. The excitons migrates to the interface of electron donor / acceptor of material, and transfer electrons to the electron acceptor material, such as PCBM, resulting in charge separation and free carriers, namely, free electrons and holes. These free electrons pass along the electron acceptor material to the metal cathode and are collected by cathode, free holes pass along electron donor material to the ITO anode and are collected by anode to generate photocurrent and photovoltage, achieve photon-to-electron conversion. When it connects to load 16, it can be supplied with power. In this process, the copolymer comprising anthracene and benzoselenadiazole because of its very wide wavelength range of spectrum response, is able to make better use of solar energy, to obtain a higher photon-to-electron conversion efficiency, to increase the electricity production capacity of solar cell devices. And this organic material can reduce the weight of solar cell devices, and be produced by spin-coating and other technologies, facilitate to manufacture on a large scale.

Referring to Fig.4, an organic light-emitting device, in which the copolymer comprising anthracene and benzoselenadiazole in the present embodiment is provided, includes glass base layer 21, transparent anode 22, light-emitting layer 23, buffer layer 24, cathode 25, which stack successively. Transparent anode 22 can be indium tin oxide (abbr. ITO), preferably for indium tin oxide with square resistance of 10 to 20 Ω. Light-emitting layer 23 includes the copolymer comprising anthracene and benzoselenadiazole in the embodiment. The buffer layer 24 can be LiF, etc, but it is not limited to it. Cathode 25 can be, but is not limited to, metal Al or Ca, Ba, etc. Thus, in a specific embodiment, the organic light-emitting device structure is expressed as: ITO / copolymer comprising anthracene and benzoselenadiazole / LiF / Al. Layers can be formed by the existing methods, while the copolymer comprising anthracene and benzoselenadiazole can be formed on ITO by spin-coating technology.

Referring to Fig.5, an organic field-effect transistor, in which the copolymer comprises anthracene and benzoselenadiazole in the present embodiment is provided. It includes substrates 31, the insulating layer 32, the modified layer 33, the organic semiconductor layer 34 and, source electrode 35 and a drain electrode 36 set on organic semiconductor layer 34, which stack successively. The substrate 31 can be, but is not limited to, highly doped silicon (Si, the insulating layer 32 can be, but is not limited to, SiO₂ of micro-nano (450 nm for example) thickness. The organic semiconductor layer 34 uses the copolymer comprising anthracene and benzoselenadiazole. Source electrode 35 and drain 36 can use but not limited to gold. Modified layer 33 can be, but is not limited to, octadecyltrichlorosilane. Substrate 31, insulating layer 32, the modified layer 33, source electrode 35 and drain 36 can be formed by the existing methods. Organic semiconductor layer 34 can be under a vacuum close to 10⁻⁴Pa, spin coating the copolymer comprising anthracene and benzoselenadiazole in the embodiment on the insulating layer 32 which is modified by the modified layer 33.

Special embodiments are disclosed as follows to demonstrate the preparation method of the copolymer comprising anthracene and benzoselenadiazole and its performance.

### Example 1

The copolymer comprising anthracene and benzoselenadiazole in the present Example 1 is abbreviated to PAn-DOTBSe, wherein a=b=1, R₁ and R₂ are H, R₃ and R₇ use OC₁₀H₂₁, X and Y are S, of which the formula is represented as the final product in the following equation.

It can be seen from the formula, the copolymer comprising anthracene and benzoselenadiazole in the present Example 1 has symmetrical structure, wherein each unit has two dithiophene rings, a benzoselenadiazole and an anthracene. With such a symmetrical structure, the copolymer comprising anthracene and benzoselenadiazole is endowed with relatively excellent stability and film-forming properties. Furthermore, it has good absorbance performance and photoelectric properties, etc.

Specific preparation of copolymer PAn-DOTBSe is described as follows:
Step 1, preparation of 9,10-bis(4,4,5,5-tetramethyl-1,3,2-dioxaboro-lane)yl-anthracene, of which the equation is represented as follows: 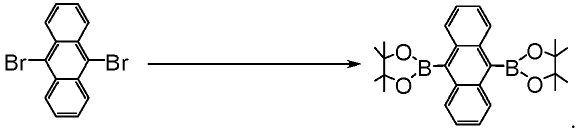
   Specific preparation is described as follows: set up an anhydrous oxygen-free reactor, under continuous stirring and a nitrogen atmosphere, add pale yellow crystal-like 9,10-dibromoanthracene (7.2 mmol) into a three-necked flask, inject 120 ml of refined tetrahydrofuran solvent with an injector, then inject 21.6 mmol of n-BuLi with injector at -78°C. The reaction system gradually turns orange red from pale yellow, stir for 2 hours. After a 2-hour reaction, inject 24.5 mmol of 2-isopropoxy-4,4,5,5-tetramethyl-1,3,2-dioxaborolane with an injector at -78°C, the whole reaction system turns pale yellow from orange red. When the temperature rises to room temperature, conduct the reaction overnight. After the reaction, add saturated sodium chloride aqueous solution, extract with chloroform and dry with anhydrous sodium sulfate. Collect the filtrate and rotary evaporate solvent after leaching. Separate the colature by column chromatography on silica gel column with petroleum ether-ethyl acetate used as eluent to get final product. The test result is GC-MS (EI-m/z): 430 (M⁺).
Step 2, preparation of 4,7-bis(5-bromo-3-decyloxythiophene)yl-2,1,3-benzoselenadiazole, which reacts as follows: 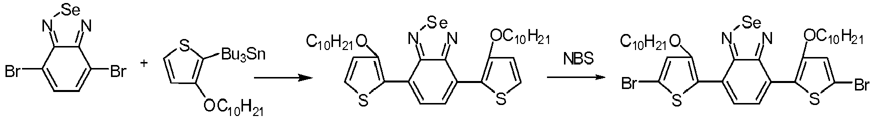
   Specific preparation is described as follows: (1) dissolve 4,7-dibromo-2,1,3-benzoselenadiazole (1 mmol) and 2-tributylstannyl-3-decyloxyl thiophene (2.2 mmol) in anhydrous methylbenzene solvent, then add palladium-tetrakis(triphenylphosphine) (0.03 mmol), reflux and react under a nitrogen atmosphere overnight. After cooling, make it precipitate in methanol solvent to get the product in 68% yield after purification on silica gel column, GC-MS (EI-m/z): 347 (M⁺).
   (2) dissolve 1 mmol of the product in step (1) and 2.3 mmol of *N-*bromosuccinimide (NBS) in 200 ml of chloroform solvent, add into a two-necked flask under the an argon atmosphere and stir continuously, conduct the reaction at room temperature in opaque background for 50 hours. Adding the product into 200 ml of methanol solvent, gradually a solid is being precipitated, filtering, washing colature with hot methanol 2 times. Conducting a purification by column chromatography on silica gel column to get solid powder product in 72% yield, GC-MS (EI-m/z): 505 (M⁺).
Step 3, preparation of copolymer PAn-DOTBSe, of which the equation is represented as follows: 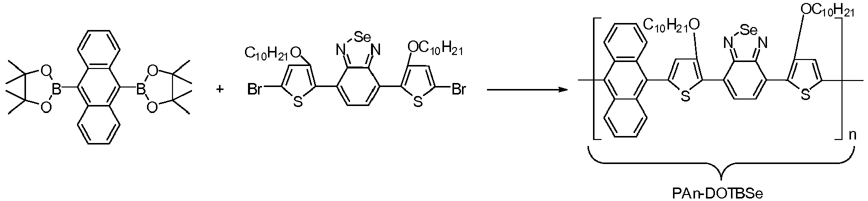
   Specific preparation is described as follows: add 9,10-bis(4,4,5,5-tetramethyl-1,3,2-dioxaborolane)yl-anthracene (1.0mmol), 4,7-bis(5-bromo-3-decyl-oxythiophene)yl-2,1,3-benzoselenadiazole (1.0 mmol), palladium-tetrakis (triphenylphosphine) (0.025 mmol), 2 mol/L sodium carbonate aqueous solution (5 ml) and methylbenzene solvent (30 ml) into a reactor, make the reaction system free of oxygen by supplying N₂ and applying a vacuum and react at 90°C for 70 h. After the reaction, add deionized water and methylbenzene into the reaction flask of product to carry out the extraction. Take the organic phase, evaporate the polymer/ methylbenzene solution to around 5 ml by vacuum distillation, drip it into 300 ml of anhydrous methanol and stir continuously for about 4 hours, a solid will gradually precipitate. The solid powder is obtained after being leached and dried. Dissolve the solid powder in chloroform, purify by means of column chromatography on neutral aluminum oxide chromatographic column to remove catalyst palladium-tetrakis(triphenylphosphine), and then rotary evaporate the polymer / chloroform solution to around 5 ml, drip it into methanol solvent and stir for several hours, then collect and dry the polymer PAn-DOTBSe, extract polymer in Soxhlet extractor to improve the monodispersity of the polymer molecular weight. The yield is about 58%. Test Polymer PAn-DOTBSe by GPC, number-average molecular weight is about 84870. The monodispersity of the polymer is 1.86.

### Example 2

The copolymer in the present embodiment is abbreviated to PODA-BSe, wherein b is 0, a is 1, R₁ and R₂ are 2-octyldecyl, of which the formula is represented as the final product in the following equation.

It can be seen from the formula, the copolymer in the present embodiment has symmetrical structure, each unit has a benzoselenadiazole and an anthracene, and there is alkyl chain of 18 carbon atoms on anthracene, which endows the copolymer comprising anthracene and benzoselenadiazole with relatively excellent stability and film-forming properties. Furthermore, it has good absorbance performance and photoelectric properties, etc.

Specific preparation of copolymer PODA-BSe is described as follows:
Step 1, preparation of 9,10-bis(4,4,5,5-tetramethyl-1,3,2-dioxaborolane)yl-2,6-bis(2-octyldecyl)anthracene, of which the equation is represented as follows: 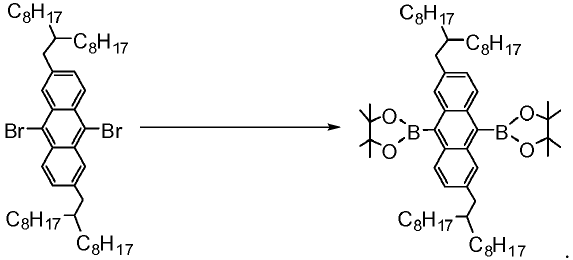
   Specific preparation is described as follows: set up an anhydrous oxygen-free reactor, under continuous stirring and a nitrogen atmosphere, add 9,10-dibromo-2,6-bis(2-octyldecyl)anthracene (5 mmol) into a three-necked flask, inject 150 ml of refined tetrahydrofuran solvent with an injector, then add 15 mmol of *n-*BuLi at -78°C, stir for 2 hours. After a 2-hour reaction, inject 15 mmol of 2-isopropoxy-4,4,5,5-tetramethyl-1,3,2-dioxaborolane with injector at -78°C. When the temperature rises to room temperature, conduct the reaction overnight. After the reaction, add saturated sodium chloride aqueous solution, extract with chloroform, dry with anhydrous sodium sulfate. Collect the filtrate and rotary evaporate solvent after leaching. Separate the colature by column chromatography on silica gel column with an appropriate solvent used as eluent to obtain the final product. The test result is GC-MS (EI-m/z): 935 (M⁺).
Step 2, preparation of copolymer PODA-BSe, of which the equation is represented as follows: 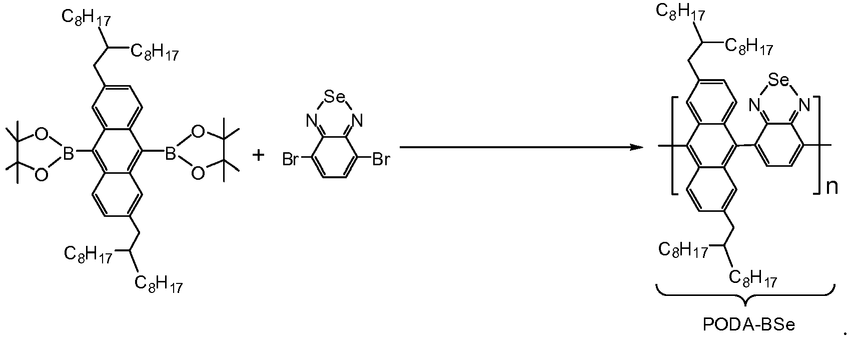
   Specific preparation is described as follows: add 9,10-bis(4,4,5,5-tetramethyl-1,3,2-dioxaborolane)yl-2,6-bis(2-octyldecyl)anthracene (1 mmol), 4,7-dibromo-2,1,3-benzoselenadiazole (1 mmol), palladium-tetrakis (triphenylphosphine) (0.015 mmol), 2 mol/L sodium carbonate aqueous solution (4 ml) and methylbenzene solvent (20 ml) into a two-necked flask, make the reaction system free of oxygen by supplying N₂ and applying a vacuum and react at 60°C for 72 h. After the reaction, add deionized water and methylbenzene into the reaction flask to carry out the extraction. Take the organic phase, evaporate the polymer/ methylbenzene solution to around 5 ml by vacuum distillation, drip it into 300 ml of anhydrous methanol and stir continuously for about 4 hours, a solid will gradually precipitate. The solid powder is obtained after being leached and dried. Dissolve the solid powder in chloroform, purify by means of column chromatography on neutral aluminum oxide chromatographic column to remove catalyst palladium-tetrakis (triphenylphosphine), and then rotary evaporate the polymer/chloroform solution, collect and dry the polymer. The yield is about 61%. Test Polymer PODA-BSe by GPC, number-average molecular weight is about 9400. The monodispersity of the polymer is 1.63.

### Example 3

The copolymer in the present embodiment is abbreviated to PODA-SeBSe, wherein a=b=1, R₁ and R₂ are 2-octyldecyl, R₃ and R₇ are H, X and Y are Se, of which the formula is represented as the final product in the following equation.

It can be seen from the formula, the copolymer comprising anthracene and benzoselenadiazole in the present embodiment has symmetrical structure, each unit has two selenophenes, a benzoselenadiazole and an anthracene. With such symmetrical structure and the alkyl chain of 18 carbon atoms on anthracene, the copolymer comprising anthracene and benzoselenadiazole is endowed with relatively excellent stability and film-forming properties. Furthermore, it has good absorbance performance and photoelectric properties, etc.

Specific preparation of copolymer PODA-SeBSe is described as follows:
Step 1, preparation of 9,10-bis(4,4,5,5-tetramethyl-1,3,2-dioxaborolane)yl-2,6-bis(2- octyldecyl)anthracene, preparation of this compound is almost the same as that in the Example 2, which it is not discussed here, with reference to the above steps.
Step 2, preparation of 4,7-bis(5'-bromo-2'-selenophen)yl-2,1,3-benzoselenadiazole, of which the equation is represented as follows: 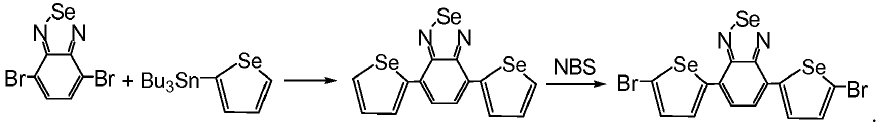
   Specific preparation is described as follows:
   (1) dissolve 4,7-dibromo-2,1,3-benzoselenadiazole(1 mmol) and 2-tributylstannyl selenophene (2.2 mmol) in anhydrous methylbenzene solvent, then add palladium-tetrakis(triphenylphosphine) (0.03 mmol), reflux and react under the protection of nitrogen overnight. After cooling, make it precipitate in methanol solvent to get 4,7-bis(2'-selenophen)yl-2,1,3-benzoselenadiazole in 61% yield after purification on silica gel column, GC-MS (EI-m/z): 441 (M⁺).
   (2) dissolve 1 mmol of 4,7-bis(2'-selenophen)yl-2,1,3-benzoselenadiazole and 2.3 mmol of N-bromosuccinimide (NBS) in 200 ml of chloroform solvent, add into two-necked flask under the protection of argon and stirring continuously, conduct the reaction at room temperature in opaque background for 50 hours. Add the product to 200 ml of methanol solvent, a solid will gradually precipitate, filter, wash the colature with hot methanol 2 times. Conduct purification by column chromatography on silica gel column to obtain the solid powder product 4,7-bis(5'-bromo-2'-selenophen)yl-2,1,3-benzoselenadiazole in 65% yield. The test result is GC-MS (EI-m/z): 599 (M⁺).
Step 3, preparation of copolymer PODA-SeBSe, of which the equation is represented as follows:

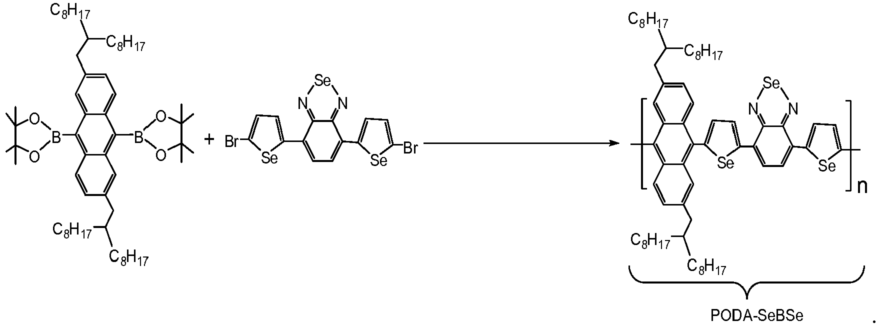

Specific preparation is described as follows: add 9,10-bis(4,4,5,5-tetramethyl-1,3,2-dioxaborolane)yl-2,6-bis(2-octyldecyl)anthracene (1 mmol), 4,7-bis(5'-bromo-2'-selenophen)yl-2,1,3-benzoselenadiazole (1 mmol), palladium-tetrakis (triphenylphosphine) (0.015 mmol), 2 mol/L sodium carbonate aqueous solution (4 ml) and methylbenzene solvent (20 ml) into a two-necked flask, make the reaction system free of oxygen by supplying N₂ and applying a vacuum and react at 90°C for 62 h. After the reaction, add deionized water and methylbenzene into the reaction flask to carry out the extraction. Take the organic phase, evaporate the polymer/ methylbenzene solution to around 5 ml by vacuum distillation, drip it into 300 ml of anhydrous methanol and stir continuously for about 4 hours and a solid will gradually precipitate. The solid powder is obtained after being leached and dried. Dissolve the solid powder in chloroform, purify by means of column chromatography on neutral aluminum oxide chromatographic column to remove catalyst palladium-tetrakis(triphenylphosphine), and then rotary evaporate the polymer / chloroform solution, collect and dry the polymer. The yield is about 58%. Test polymer PODA-SeBSe by GPC, number-average molecular weight is about 78600. The monodispersity of the polymer is 1.81.

### Example 4

The copolymer in the present embodiment is abbreviated to PODA-DBSe, wherein a is 2, b is 0, R₁ and R₂ are 2-octyldecyl, of which the formula is represented as the final product in the following equation.

It can be seen from the formula, the copolymer in the present embodiment has better symmetrical structure, and each unit has two benzoselenadiazoles and an anthracene. With such a symmetrical structure and the alkyl chain of 18 carbon atoms on anthracene, the copolymer comprising anthracene and benzoselenadiazole is endowed with relatively excellent stability and film-forming properties. On the other hand, the copolymer has double benzoselenadiazole structure, which provides good absorbance performance and photoelectric properties, etc.

Specific preparation of PODA-DBSe is described as follows:
Step 1, preparation of 3-bromo-1,2-diaminobenzene, of which the equation is represented as follows: 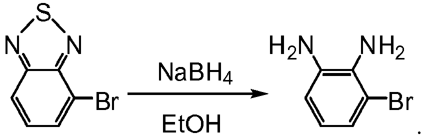
   Specific preparation is described as follows: dissolve 4-bromo-2,1,3-benzothiadiazole(20 mmol) in ethanol solvent (180 ml), add sodium borohydride (0.38mmol) at 0°C, then raise the temperature to room temperature, stir for 24 hours, distill organic solvent of the reaction product, after adding water (200 ml), wash with saline water, then extract with diethyl ether and dry with anhydrous sodium sulfate. The product is obtained after the solvent is rotary dried. The test result is GC-MS (EI-m/z): 186 (M+).
Step 2, preparation of 4-bromo-2,1,3-benzoselenadiazole, of which the equation is represented as follows: 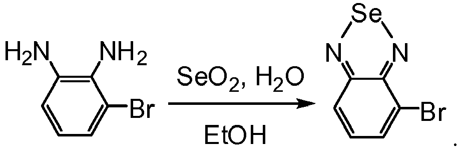
   Specific preparation is described as follows: reflux 3-bromo-1,2-diaminobenzene (10 mmol) in 60 ml of ethanol solution, then add into selenium dioxide (10.5 mmol) dissolved in hot water (20 ml) for a 2-hour refluxing reaction. The precipitate is recrystallized with ethyl acetate after being filtered to obtain the product. GC-MS (EI-m/z): 262 (M+).
Step 3, preparation of 4-4,4,5,5-tetramethyl-1,3,2-dioxaborolane-2,1,3-benzoselenadiazole, of which the equation is represented as follows: 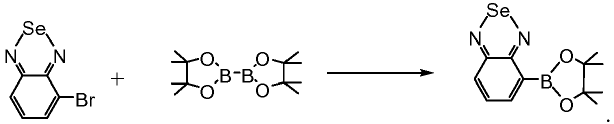
   Specific preparation is described as follows: dissolve 4-bromo-2,1,3-benzoselenadiazole (2.33 mmol), bis(pinacolato)diboro (2.79 mmol), potassium acetate (6.66 mmol) in dry 1,4-dioxane (7 ml) and bubble with nitrogen for 30 minutes. Then add 1,1-bis(diphenylphosphino)ferrocene palladium dichloride (0.116 mmol), heat and stir for 20 hours at 105 °C. Extract with ethyl acetate after washing with saturated salt solution, dry through anhydrous sodium sulfate, separate and purify on silica gel column with ethyl acetate and normal hexane used as solvent to obtain the product. The test result is GC-MS (EI-m/z): 309 (M+).
Step 4, preparation of bis(2,1,3-benzoselenadiazole), of which the equation is represented as follows: 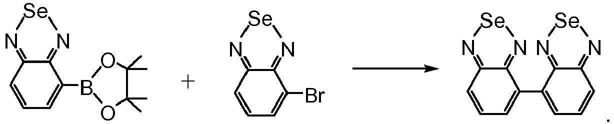
   Specific preparation is described as follows: place a borate ester substituted product of 4-bromo-2,1,3-benzoselenadiazole (5 mmol) and 4-bromo-2,1,3-benzoselenadiazole (4.5 mmol), palladium-tetrakis(triphenylphosphine) (0.075 mmol), sodium carbonate aqueous solution into a three-necked flask, stir for 20 hours under the deoxygenization at 100°C. Extract with dichloromethane after washing with saturated salt solution, dry through anhydrous sodium sulfate, separate and purify on silica gel column with ethyl acetate and normal hexane used as solvent to obtain the product. GC-MS (EI-m/z): 366 (M+).
Step 5, preparation of 7,7'-dibromo-4,4'-bis(2,1,3-benzoselenadiazole), of which the equation is represented as follows: 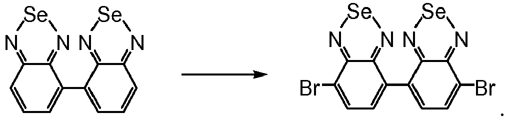
   Specific preparation is described as follows: dissolving dibenzoselenadiazole (1 mmol) in hydrobromide (10 ml), adding Br2 (4.5 mmol), stirring for 3 days at 130 °C. Add saturated sodium sulfate solution, leach and vacuum dry to obtain the product, that is, 7,7'-dibromo-4,4'-bis(2,1,3-benzoselenadiazole). The test result is GC-MS (EI-m/z): 522 (M+).
Step 6, preparation of copolymer PODA-DBSe, of which the equation is represented as follows: 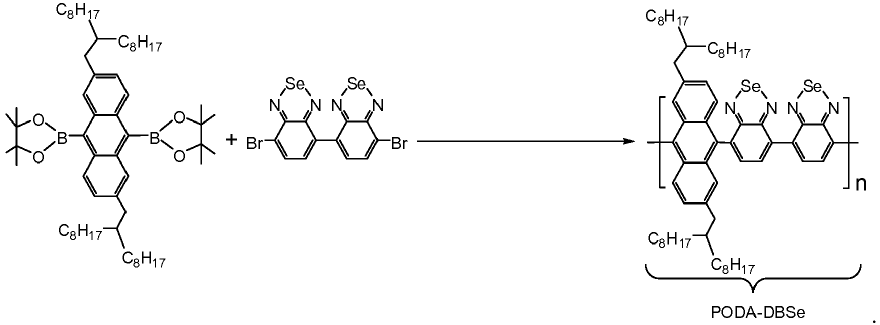
   Specific preparation is described as follows: Add 9,10-bis(4,4,5,5-tetramethyl-1,3,2-dioxaborolane)yl-2,6-bis(2-octyldecyl)anthracene (1 mmol), 7,7'-dibromo-4,4'-bis(2,1,3-benzoselenadiazole) (1 mmol), palladium-tetrakis (triphenylphosphine) (0.015 mmol), 2 mol/L sodium carbonate aqueous solution (3 ml) and methylbenzene solvent (30 ml) into a two-necked flask, make the reaction system free of oxygen by supplying N₂ and applying a vacuum and react at 100°C for 48 h. After the reaction, add deionized water and methylbenzene into the reaction flask of the product to carry out the extraction. Take the organic phase, evaporate the polymer/ methylbenzene solution to around 5 ml by vacuum distillation, drip it into 300 ml of anhydrous methanol and stir continuously for about 3 hours and a solid gradually precipitates. The solid powder is obtained after being leached and dried. Dissolve the solid powder in chloroform, purify by means of column chromatography on neutral aluminum oxide chromatographic column to remove catalyst palladium-tetrakis (triphenylphosphine), and then rotary evaporate the polymer / chloroform solution, collect and dry the polymer. The yield is about 63%. Test Polymer PODA-DBSe by GPC, number-average molecular weight is about 79100. The monodispersity of the polymer is 1.88.

### Example 5

The copolymer in the present embodiment is abbreviated to PODA-DTBSe, which is short for polymer of 2,6-bis(2-octyldecyl)anthracene and 7,7-dithiophenyl-bis(2,1,3-benzoselenadiazole), wherein a=b=2, R₁ and R₂ are 2-octyldecyl, R₃ and R₇ are H, of which the formula is represented as the final product in the following equation.

It can be seen from the formula, the copolymer in the present embodiment has a better symmetrical structure, and each unit has two benzoselenadiazoles, four dithiophenes and an anthracene. With such a symmetrical structure, the copolymer comprising anthracene and benzoselenadiazole is endowed with relatively excellent stability and film-forming properties. Also, it has good absorbance performance and photoelectric properties, etc.

Specific preparation of copolymer PODA-SeBSe is described as follows:
Step 1, obtaining 3-bromo-1,2-diaminobenzene using steps 1-5 in Example 4, which is not discussed here.
Step 2, preparation of 7,7-bis(5'-bromo-dithiophene)yl-bis(2,1,3-benzoselenadiazole), that is, preparation of compound B, where the reaction flow is described as follows: 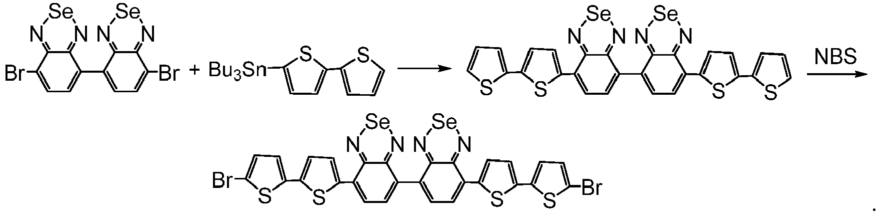
   Specific preparation is described as follows:
   (1) Specific preparation is described as follows: dissolve 7,7'-dibromo-4,4'-bis(2,1,3-benzoselenadiazole) (1 mmol) and 2-tributylstannyl-bithiophene (2.2 mmol) in anhydrous methylbenzene solvent, then add palladium-tetrakis(triphenylphosphine) (0.03 mmol), reflux and react under a nitrogen atmosphere overnight. After cooling, make it precipitate in methanol solvent to obtain 7,7-dithiophenyl-bis(2,1,3-benzoselenadiazole) in 72% yield after purification on silica gel column, GC-MS (EI-m/z): 693 (M⁺).
   (2) Dissolve 7,7-dithiophenyl-bis(2,1,3-benzoselenadiazole) (1 mmol) and 2.5 mmol of N-bromosuccinimide (NBS) in chloroform solvent (200 ml), adding into a two-necked flask under an argon atmosphere and stir continuously at room temperature in opaque background for 40 hours. Add the product to 200 ml of methanol solvent, gradually a solid precipitates. Filter and wash the colature with hot methanol 2 times. Purify by column chromatography on a silica gel column to obtain solid powder 7,7-bis(5'-bromo-dithiophen)yl-bis(2,1,3-benzoselenadiazole) in 74% yield, GC-MS (EI-m/z): 850 (M⁺).
Step 3, preparation of copolymer PODA-DTBSe, of which the equation is described as follows:

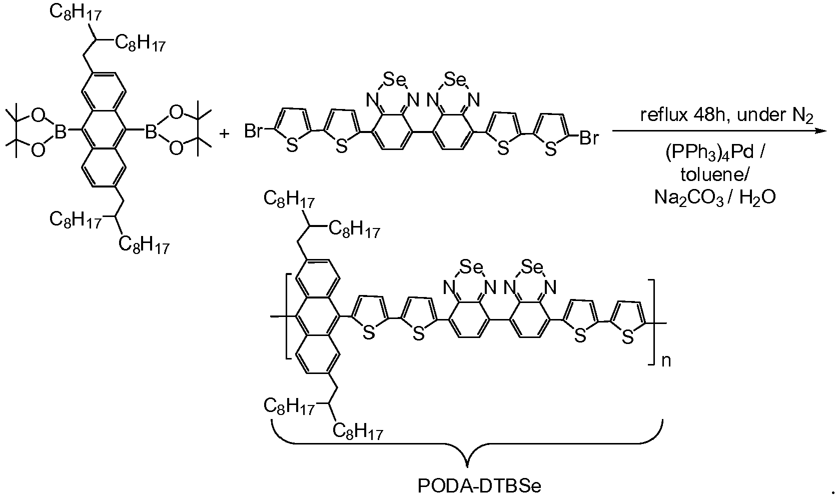

Specific preparation is described as follows: add 9,10-bis(4,4,5,5-tetramethyl-1,3,2-dioxaborolane)yl-2,6-bis(2-octyldecyl)anthracene (1 mmol), 7,7-bis (5'-bromo-dithiophen)yl-bis(2,1,3-benzoselenadiazole) (1 mmol), palladium-tetrakis (triphenylphosphine) (0.015 mmol), 2 mol/L sodium carbonate aqueous solution (4 ml) and methylbenzene solvent (30 ml) into a two-necked flask, make the reaction system free of oxygen by supplying N₂ and applying a vacuum and react at 105°C for 48 h. After a 48-hour reaction, add deionized water and methylbenzene into a reaction flask to carry out the extraction. Take the organic phase, evaporate the polymer/ methylbenzene solution to around 5 ml by vacuum distillation method, drip it into 300 ml of anhydrous methanol and stir continuously for 3 hours, gradually a solid precipitates. The solid powder is obtained after being leached and dried. Dissolve the solid powder in chloroform, purifying by means of column chromatography on neutral aluminum oxide chromatographic column to remove catalyst palladium-tetrakis(triphenylphosphine), and then rotary evaporate the polymer / chloroform solution, collect and dry the polymer. Test Polymer PODA-DTBSe by GPC, number-average molecular weight is about 54200. The monodispersity of the polymer is 2.43.

While the present invention has been described with reference to particular embodiments, it will be understood that the embodiments are illustrative. Alternative embodiments of the present invention will become apparent to those having ordinary skill in the art to which the present invention pertains.

## Claims

1. A copolymer comprising anthracene and benzoselenadiazole, which is represented by formula (I), 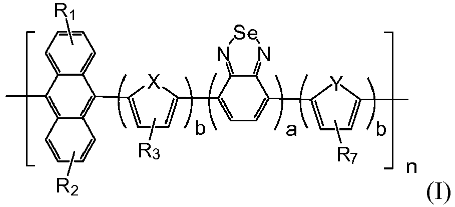
wherein n is a natural number from 10 to 1000,
a is 1 or 2,
b is 0, 1 or 2;
X, Y are O, S, Se or SO₂, N-R₄, R₅-Si-R₆;
R₄, R₅, R₆ are selected from C₁-C₂₀ straight-chain, branched-chain or cyclo alkyl or alkoxy;
R₁, R₂ are unsubstituted, monosubstituted or polysubstituted functional group Ar_{1.} and the functional group An is selected from hydrogen, halogen, cyano, substituted or unsubstituted C₁-C₄₀ straight-chain or branched-chain or cyclo alkyl, substituted or unsubstituted aryl or heteroaryl;
R₃, R₇ are unsubstituted, monosubstituted or polysubstituted functional group Ar₂, and the functional group Ar₂ is selected from hydrogen, cyano, substituted or unsubstituted C₁-C₄₀ straight-chain or branched-chain or cyclo alkyl, substituted or unsubstituted C₁-C₄₀ alkoxy, substituted or unsubstituted C₆-C₄₀ aryl, substituted or unsubstituted C₆-C₄₀ aralkyl substituted or unsubstituted C₆-C₄₀ aryl alkoxy.

2. The copolymer comprising anthracene and benzoselenadiazole according to claim 1, wherein R₁ and R₂ are the same functional group Ar₁, and the functional group Ar₁ is halogen, cyano, substituted or unsubstituted C₁-C₄₀ straight-chain or branched-chain or cyclo alkyl, substituted or unsubstituted aryl or heteroaryl.

3. The copolymer comprising anthracene and benzoselenadiazole according to claim 1, wherein
b is 1 or 2,
R₃, R₇ are the same functional group Ar₂, and the functional group Ar₂ is selected from cyano, substituted or unsubstituted C₁-C₄₀ straight-chain or branched-chain or cyclo alkyl, substituted or unsubstituted C₁-C₄₀ alkoxy, substituted or unsubstituted C₆-C₄₀ aryl, substituted or unsubstituted C₆-C₄₀ aralkyl, substituted or unsubstituted C₆-C₄₀ aryl alkoxy.

4. The copolymer comprising anthracene and benzoselenadiazole according to claim 1, wherein n is an integer from 10 to 100.

5. A method of preparing a copolymer comprising anthracene and benzoselenadiazole, comprising:
providing the compounds A and B represented by the following formula, respectively:
A: 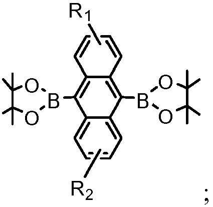 B: 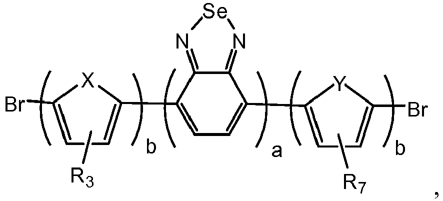 wherein
a is 1 or 2;
b is 0,1 or 2;
X, Y are O, S, Se or SO₂, N-R₄, R₅-Si-R₆;
R₄, R₅, R₆ are selected from C₁-C₂₀ straight-chain, branched-chain or cyclo alkyl or alkoxy;
R₁, R₂ are unsubstituted, monosubstituted or polysubstituted functional group An, and the functional group An is selected from hydrogen, halogen, cyano, substituted or unsubstituted C₁-C₄₀ straight-chain or branched-chain or cyclo alkyl, substituted or unsubstituted aryl or heteroaryl;
R₃, R₇ are unsubstituted, monosubstituted or polysubstituted functional group Ar₂, and the functional group Ar₂ is selected from hydrogen, cyano, substituted or unsubstituted C₁-C₄₀ straight-chain or branched-chain or cyclo alkyl, substituted or unsubstituted C₁-C₄₀ alkoxy, substituted or unsubstituted C₆-C₄₀ aryl, substituted or unsubstituted C₆-C₄₀ aralkyl, substituted or unsubstituted C₆-C₄₀ aryl alkoxy;
compound A and compound B were polymerized in the presence of a catalyst, an alkaline solution and an organic solvent and under an oxygen-free environment, wherein the polymerization is represented by the following formula: 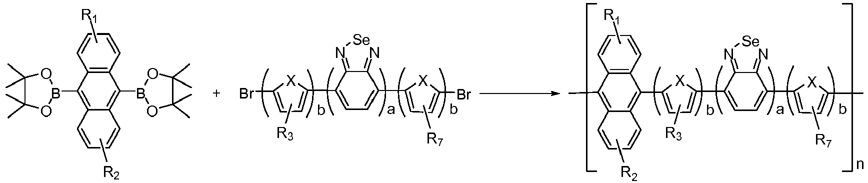
wherein n is a natural number from 10 to 1000, to produce the copolymer comprising anthracene and benzoselenadiazole.

6. A method of preparing a copolymer comprising anthracene and benzoselenadiazole according to claim 5, wherein the polymerization product is purified after being obtained and the purification is conducted by dissolving the polymerization product in chloroform, purifying by means of column chromatography on neutral aluminum oxide chromatographic column, removing catalyst, and then rotary evaporating the polymerization product and chloroform solution, dripping methanol solvent and stirring for several hours, drying, extracting the copolymer using a Soxhlet extractor, thereby obtaining the copolymer comprising anthracene and benzoselenadiazole.

7. A method of preparing a copolymer comprising anthracene and benzoselenadiazole according to claim 5, wherein the catalyst is an organopalladium catalyst or a mixture of an organopalladium catalyst and organic phosphine ligands, of which the amount is equivalent to 0.5%-10% of the molar amount of compound A, the provided organic solvent is methylbenzene, tetrahydrofuran, glycol dimethyl ether, benzene or *N*,*N-*dimethyl formamide, the alkaline solution is metal hydroxide, aqueous solution of metal carbonate or aqueous solution of alkyl ammonium hydroxide, the amount of it is 5 to 10 times as much as the molar amount of compound A.

8. A method of preparing a copolymer comprising anthracene and benzoselenadiazole according to claim 5, wherein the catalyst is an organopalladium catalyst or a mixture of an organopalladium catalyst and organic phosphine ligands and in the mixture the molar ratio of organopalladium catalyst to organic phosphine ligands is 1:2 to 20.

9. A method of preparing a copolymer comprising anthracene and benzoselenadiazole according to claim 5, wherein the polymerization temperature is in the range of 60°C to 100°C for 1 to 7 days.

10. Use of a copolymer comprising anthracene and benzoselenadiazole according to any one of claims 1 to 4 in organic optoelectronic materials, polymer solar cell devices, organic field effect transistors, organic light-emitting devices, organic optical storage devices, organic nonlinear materials or organic laser devices.

## Patentansprüche

1. Copolymer, umfassend Anthracen und Benzoselenadiazol, dargestellt durch die Formel (I), 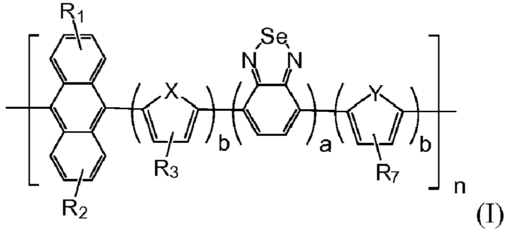
worin n eine natürliche Zahl von 10 bis 1000 ist,
a = 1 oder 2 ist,
b = 0, 1 oder 2 ist;
X, Y O, S, Se oder SO₂, N-R₄, R₅-Si-R₆ sind;
R₄, R₅, R₆ aus unverzweigtem, verzweigtem oder Cyclo-C₁-C₂₀-Alkyl oder -Alkoxy ausgewählt sind,
R₁, R₂ unsubstituierte, monosubstituierte oder polysubstituierte funktionelle Gruppe Ar₁ sind und die funktionelle Gruppe Ar₁ aus Wasserstoff, Halogen, Cyano, substituiertem oder unsubstituiertem unverzweigtem oder verzweigtem oder Cyclo-C₁-C₄₀-Alkyl, substituiertem oder unsubstituiertem Aryl oder Heteroaryl ausgewählt ist;
R₃, R₇ unsubstituierte, monosubstituierte oder polysubstituierte funktionelle Gruppe Ar₂ sind und die funktionelle Gruppe Ar₂ aus Wasserstoff, Cyano, substituiertem oder unsubstituiertem unverzweigtem oder verzweigtem oder Cyclo-C₁-C₄₀-Alkyl, substituiertem oder unsubstituiertem C₁-C₄₀-Alkoxy, substituiertem oder unsubstituiertem C₆-C₄₀-Aryl, substituiertem oder unsubstituiertem C₆-C₄₀-Aralkyl, substituiertem oder unsubstituiertem C₆-C₄₀-Arylalkoxy ausgewählt ist.

2. Copolymer, umfassend Anthracen und Benzoselenadiazol, nach Anspruch 1, wobei R₁ und R₂ dieselbe funktionelle Gruppe Ar₁ sind und die funktionelle Gruppe Ar₁ Halogen, Cyano, substituiertes oder unsubstituiertes unverzweigtes oder verzweigtes oder Cyclo-C₁-C₄₀-Alkyl ist oder substituiertes oder unsubstituiertes Aryl oder Heteroaryl ist.

3. Copolymer, umfassend Anthracen und Benzoselenadiazol, nach Anspruch 1, worin
b = 1 oder 2 ist,
R₃, R₇ dieselbe funktionelle Gruppe Ar₂ sind und die funktionelle Gruppe Ar₂ aus Cyano, substituiertem oder unsubstituiertem unverzweigtem oder verzweigtem oder Cyclo-C₁-C₄₀-Alkyl, substituiertem oder unsubstituiertem C₁-C₄₀-Alkoxy, substituiertem oder unsubstituiertem C₆-C₄₀-Aryl, substituiertem oder unsubstituiertem C₆-C₄₀-Aralkyl, substituiertem oder unsubstituiertem C₆-C₄₀-Arylalkoxy ausgewählt ist.

4. Copolymer, umfassend Anthracen und Benzoselenadiazol, nach Anspruch 1, worin n eine ganze Zahl von 10 bis 100 ist.

5. Verfahren zur Herstellung eines Anthracen und Benzoselenadiazol umfassenden Copolymers, das Folgendes umfasst:
Bereitstellen der Verbindungen A und B, die jeweils durch die folgenden Formeln dargestellt sind:
A: 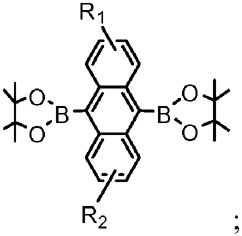 B: 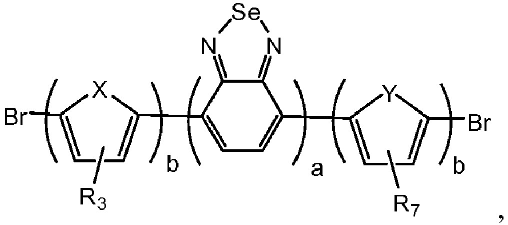 worin
a = 1 oder 2 ist;
b = 0,1 oder 2 ist;
X, Y O, S, Se oder SO₂, N-R₄, R₅-Si-R₆ sind;
R₄, R₅, R₆ aus unverzweigtem, verzweigtem oder Cyclo-C₁-C₂₀-Alkyl oder -Alkoxy ausgewählt sind,
R₁, R₂ unsubstituierte, monosubstituierte oder polysubstituierte funktionelle Gruppe Ar₁ sind und die funktionelle Gruppe Ar₁ aus Wasserstoff, Halogen, Cyano, substituiertem oder unsubstituiertem unverzweigtem oder verzweigtem oder Cyclo-C₁-C₄₀-Alkyl, substituiertem oder unsubstituiertem Aryl oder Heteroaryl ausgewählt ist;
R₃, R₇ unsubstituierte, monosubstituierte oder polysubstituierte funktionelle Gruppe Ar₂ sind und die funktionelle Gruppe Ar₂ aus Wasserstoff, Cyano, substituiertem oder unsubstituiertem unverzweigtem oder verzweigtem oder Cyclo-C₁-C₄₀-Alkyl, substituiertem oder unsubstituiertem C₁-C₄₀-Alkoxy, substituiertem oder unsubstituiertem C₆-C₄₀-Aryl, substituiertem oder unsubstituiertem C₆-C₄₀-Aralkyl, substituiertem oder unsubstituiertem C₆-C₄₀-Arylalkoxy ausgewählt ist;
Verbindung A und Verbindung B in Gegenwart eines Katalysators, einer alkalischen Lösung und eines organischen Lösungsmittels und unter sauerstofffreier Umgebung polymerisiert wurden, wobei die Polymerisation durch die folgende Formel dargestellt ist: 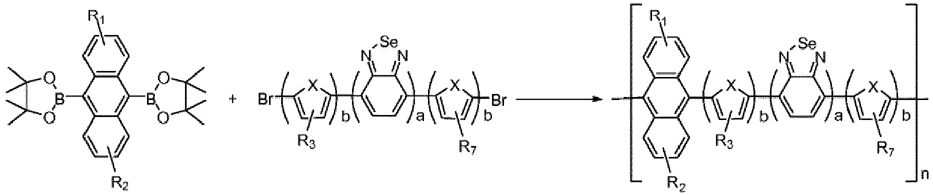
worin n eine natürlich Zahl von 10 bis 1000 ist, um das Copolymer umfassend Anthracen und Benzoselenadiazol herzustellen.

6. Verfahren zur Herstellung eines Anthracen und Benzoselenadiazol umfassenden Copolymers nach Anspruch 5, wobei das Polymerisationsprodukt, nachdem es erhalten wurde, gereinigt wird und die Reinigung erfolgt, indem das Polymerisationsprodukt in Chloroform gelöst wird, mittels Säulenchromatographie auf einer neutralen Aluminiumoxid-Chromatographiesäule gereinigt wird, der Katalysator entfernt wird, dann das Polymerisationsprodukt und die Chloroformlösung rotationsverdampft wird, Methanollösung abgetropft und mehrere Stunden lang gerührt wird, getrocknet, das Copolymer unter Verwendung eines Soxhlet-Extraktors extrahiert wird, wodurch das Anthracen und Benzoselenadiazol umfassende Copolymer erhalten wird.

7. Verfahren zur Herstellung eines Anthracen und Benzoselenadiazol umfassenden Copolymers nach Anspruch 5, wobei der Katalysator ein Organopalladiumkatalysator oder ein Gemisch aus einem Organopalladiumkatalysator und organischen Phosphinliganden ist, deren Menge gleich 0,5 % bis 10 % der molaren Menge von Verbindung A entspricht, wobei das bereitgestellte organische Lösungsmittel Methylbenzol, Tetrahydrofuran, Glykoldimethylether, Benzol oder N,N-Dimethylformamid ist, die alkalische Lösung Metallhydroxid, wässrige Lösung von Metallcarbonat oder wässrige Lösung von Alkylammoniumhydroxid ist, deren Menge 5- bis 10-mal so viel ist wie die molare Menge der Verbindung A.

8. Verfahren zur Herstellung eines Anthracen und Benzoselenadiazol umfassenden Copolymers nach Anspruch 5, wobei der Katalysator ein Organopalladiumkatalysator oder ein Gemisch aus einem Organopalladiumkatalysator und organischen Phosphinliganden ist und im Gemisch das Molverhältnis von Organopalladiumkatalysator zu organischen Phosphinliganden 1:2 bis 20 beträgt.

9. Verfahren zur Herstellung eines Anthracen und Benzoselenadiazol umfassenden Copolymers nach Anspruch 5, wobei die Polymerisationstemperatur 1 bis 7 Tage lang im Bereich von 60 °C bis 100 °C liegt.

10. Verwendung eines Anthracen und Benzoselenadiazol umfassenden Copolymers nach einem der Ansprüche 1 bis 4 in organischen optoelektronischen Materialien, Polymersolarzellvorrichtungen, organischen Feldeffekttransistoren, organischen lichtemittierenden Vorrichtungen, organischen optischen Speichervorrichtungen, organischen nichtlinearen Materialien oder organischen Laservorrichtungen.

## Revendications

1. Copolymère comprenant de l'anthracène et du benzosélénadiazole, qui est représenté par la formule (I), 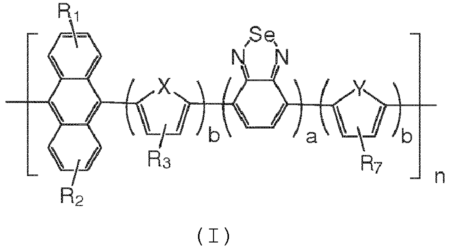
dans laquelle n est un entier naturel de 10 à 1000,
a vaut 1 ou 2,
b vaut 0, 1 ou 2 ;
X et Y sont O, S, Se ou SO₂, N-R₄, R₅-Si-R₆ ;
R₄, R₅ et R₆ sont choisis parmi les radicaux alkyle ou alcoxy en C₁ à C₂₀ linéaires, ramifiés ou cycliques ;
R₁ et R₂ sont des groupes fonctionnels Ar₁ non substitués, monosubstitués ou polysubstitués, et le groupe fonctionnel Ar₁ est choisi parmi l'hydrogène, les halogènes et les radicaux cyano, alkyle en C₁ à C₄₀ linéaires, ramifiés ou cycliques, substitués ou non substitués, et aryle ou hétéroaryle substitués ou non substitués ;
R₃ et R₇ sont des groupes fonctionnels Ar₂ non substitués, monosubstitués ou polysubstitués, et le groupe fonctionnel Ar₂ est choisi parmi l'hydrogène et les radicaux cyano, alkyle en C₁ à C₄₀ linéaires, ramifiés ou cycliques, substitués ou non substitués, alcoxy en C₁ à C₄₀ substitués ou non substitués, aryle en C₆ à C₄₀ substitués ou non substitués, aralkyle en C₆ à C₄₀ substitués ou non substitués, et arylalcoxy en C₆ à C₄₀ substitués ou non substitués.

2. Copolymère comprenant de l'anthracène et du benzosélénadiazole selon la revendication 1, dans lequel R₁ et R₂ sont le même groupe fonctionnel Ar₁, et le groupe fonctionnel Ar₁ est un halogène ou un radical cyano, alkyle en C₁ à C₄₀ linéaire, ramifié ou cyclique, substitué ou non substitué, aryle ou hétéroaryle substitué ou non substitué.

3. Copolymère comprenant de l'anthracène et du benzosélénadiazole selon la revendication 1, dans lequel b vaut 1 ou 2,
R₃ et R₇ sont le même groupe fonctionnel Ar₂, et le groupe fonctionnel Ar₂ est choisi parmi les radicaux cyano, alkyle en C₁ à C₄₀ linéaires, ramifiés ou cycliques, substitués ou non substitués, alcoxy en C₁ à C₄₀ substitués ou non substitués, aryle en C₆ à C₄₀ substitués ou non substitués, aralkyle en C₆ à C₄₀ substitués ou non substitués, et arylalcoxy en C₆ à C₄₀ substitués ou non substitués.

4. Copolymère comprenant de l'anthracène et du benzosélénadiazole selon la revendication 1, dans lequel n est un entier de 10 à 100.

5. Procédé pour préparer un copolymère comprenant de l'anthracène et du benzosélénadiazole, comprenant les opérations consistant à :
disposer des composés A et B représentés par les formules respectives suivantes :
A: 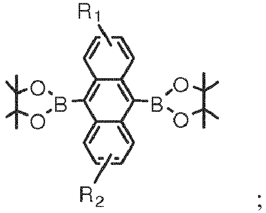 B: 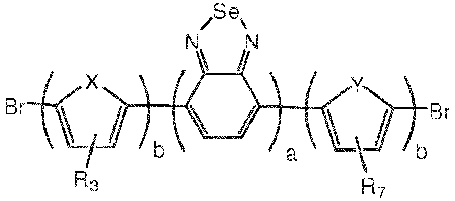 dans lesquelles
a vaut 1 ou 2 ;
b vaut 0, 1 ou 2 ;
X et Y sont O, S, Se ou SO₂, N-R₄, R₅-Si-R₆ ;
R₄, R₅ et R₆ sont choisis parmi les radicaux alkyle ou alcoxy en C₁ à C₂₀ linéaires, ramifiés ou cycliques ;
R₁ et R₂ sont des groupes fonctionnels Ar₁ non substitués, monosubstitués ou polysubstitués, et le groupe fonctionnel Ar₁ est choisi parmi l'hydrogène, les halogènes et les radicaux cyano, alkyle en C₁ à C₄₀ linéaires, ramifiés ou cycliques, substitués ou non substitués, et aryle ou hétéroaryle substitués ou non substitués ;
R₃ et R₇ sont des groupes fonctionnels Ar₂ non substitués, monosubstitués ou polysubstitués, et le groupe fonctionnel Ar₂ est choisi parmi l'hydrogène et les radicaux cyano, alkyle en C₁ à C₄₀ linéaires, ramifiés ou cycliques, substitués ou non substitués, alcoxy en C₁ à C₄₀ substitués ou non substitués, aryle en C₆ à C₄₀ substitués ou non substitués, aralkyle en C₆ à C₄₀ substitués ou non substitués, et arylalcoxy en C₆ à C₄₀ substitués ou non substitués ;
le composé A et le composé B sont polymérisés en présence d'un catalyseur, d'une solution alcaline et d'un solvant organique et dans un environnement exempt d'oxygène,
la polymérisation étant représentée par la formule suivante : 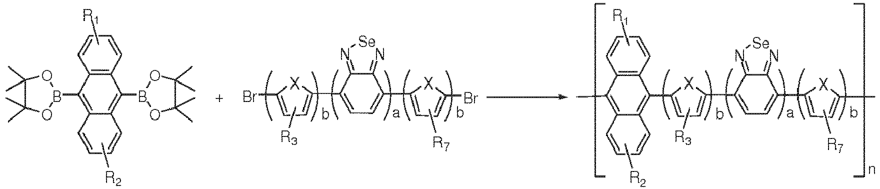
dans laquelle n est un entier naturel de 10 à 1000,
pour produire le copolymère comprenant de l'anthracène et du benzosélénadiazole.

6. Procédé pour préparer un copolymère comprenant de l'anthracène et du benzosélénadiazole selon la revendication 5, dans lequel le produit de polymérisation est purifié après avoir été obtenu et la purification est effectuée par dissolution du produit de polymérisation dans du chloroforme, purification au moyen d'une chromatographie sur une colonne chromatographique d'oxyde d'aluminium neutre, élimination du catalyseur, puis évaporation sur un évaporateur rotatif du produit de polymérisation et de la solution de chloroforme, versage de méthanol solvant et agitation pendant plusieurs heures, séchage, extraction du polymère au moyen d'un extracteur Soxhlet, ce qui donne ainsi le copolymère comprenant de l'anthracène et du benzosélénadiazole.

7. Procédé pour préparer un copolymère comprenant de l'anthracène et du benzosélénadiazole selon la revendication 5, dans lequel le catalyseur est un catalyseur au palladium organique ou un mélange d'un catalyseur au palladium organique et de ligands phosphine organiques, dont la quantité équivaut à 0,5 % à 10 % de la quantité molaire du composé A, le solvant organique fourni est le méthylbenzène, le tétrahydrofurane, l'éther diméthylique de glycol, le benzène ou le *N,N-*diméthylformamide, la solution alcaline est un hydroxyde métallique, une solution aqueuse de carbonate métallique ou une solution aqueuse d'hydroxyde d'alkyl-ammonium, dont la quantité est de 5 à 10 fois la quantité molaire du composé A.

8. Procédé pour préparer un copolymère comprenant de l'anthracène et du benzosélénadiazole selon la revendication 5, dans lequel le catalyseur est un catalyseur au palladium organique ou un mélange d'un catalyseur au palladium organique et de ligands phosphine organiques et, dans le mélange, le rapport molaire du catalyseur au palladium organique aux ligands phosphine organiques est de 1/2 à 20.

9. Procédé pour préparer un copolymère comprenant de l'anthracène et du benzosélénadiazole selon la revendication 5, dans lequel la température de polymérisation est située dans la plage allant de 60°C à 100°C pendant 1 à 7 jours.

10. Utilisation d'un copolymère comprenant de l'anthracène et du benzosélénadiazole selon l'une quelconque des revendications 1 à 4 dans des matériaux optoélectroniques organiques, des dispositifs de cellules solaires polymères, des transistors à effet de champ organiques, des dispositifs luminescents organiques, des dispositifs de stockage optique organiques, des matériaux organiques non linéaires ou des dispositifs organiques à laser.
